# EUROPEAN PATENT APPLICATION

(11) **EP 1 571 533 A2**
(43) Date of publication of application: **07.09.2005**
(21) Application number: 04005451.2
(22) Date of filing: 08.03.2004
(51) Int. Cl.: G06F 1/20

(54) **Liquid cooling system, and electronic apparatus having the same therein**

(30) Priority: 16.02.2004 JP 2004037920
(71) Applicant: Hitachi, Ltd., Tokyo 101-8010 (JP)
(72) Inventor: Naganawa, Takashi c/o Hitachi, Ltd.,Int.Prop.Group, Tokyo 100-8220 (JP); Minamitani, Rintaro c/o Hitachi,Ltd.,Int.Prop.Gr., Tokyo 100-8220 (JP); Ohashi, Shigeo c/o Hitachi, Ltd.,Int. Prop.Group, Tokyo 100-8220 (JP); Nishihara, Atsuo c/o Hitachi, Ltd.,Int. Prop.Group, Tokyo 100-8220 (JP)
(74) Representative: Beetz & Partner

(57) **Abstract**

A liquid cooling system being freely applicable to various kinds of electronic apparatuses, for cooling a CPU, which is mounted within a housing (100), the system comprises: a cooling jacket (50), a radiator (60) and a circulation pump, wherein the circulation pump is built up with a centrifugal pump, in which a rotor (730) having a plural number of blades formed in a centrifugal manner, a pump chamber (741) receiving the rotor in an inside thereof, and a field coil (712) of an electric motor for driving the rotor rotationally are formed into one body, and the pump chamber is disposed to be located below the electric motor, thereby achieving the structure so that a liquid coolant fills up the pump chamber when stopping, in spite of the disposition of the circulation pump.

## Description

### BACKGROUND OF THE INVENTION

The present invention relates to an electronic apparatus, such as, a personal computer, being so-called a desktop-type or a notebook-type, or a server, etc., and in particular, it relates to a liquid cooling system being able to cool down a heat-generation element mounted within an inside thereof, such as, a semiconductor integrated element, effectively with an aid of a liquid refrigerant or coolant, and further an electronic apparatus having such the liquid cooling system therein.

In order to maintain a normal operation thereof, cooling is necessary for the heat-generation element, such as, the semiconductor IC element, being mounted within an electronic apparatus, including a personal computer, of called the desktop-type or the notebook-type, as well as, a server, etc., and in particular, the heat-generation element, such as, a CPU (Central Processing Unit), as a representative one thereof, for example. For this reason, conventionally, such the cooling is achieved generally by using a heat transfer element, being so-called a heat sink that is formed with fins thereon, as well as a fan, being provided for sending a cooling air thereto. However, small-sizing and high integration of such the semiconductor IC element, such as the heat-generation element, in recent years, brings about localization of the heat generating at a portion thereof within the heat-generation element, and also for this reason, attention comes to be paid onto a cooling system of a liquid type of using the liquid coolant therein, such as a water, for example, being high in the cooling efficiency thereof, in the place of the conventional cooling system of an air-cooling type.

Namely, with the liquid cooling system of being high in the cooling efficiency thereof, which is used in the personal computer, of so-called the desktop-type or the notebook-type, and also the server, etc., as is known from the following patent documents, for example, in general, an element being so-called by a heat-receiving (or cooler) jacket is mounted on the surface of the heat-generating element, i.e., the CPU, directly, while conducting the liquid coolant within a flow passage formed within the heat-receiving jacket, so as to transmit or convey the heat generated from the CPU to the coolant flowing within the jacket mentioned above, thereby cooling down the heat-generating element with high efficiency. Further, in such the cooling system of the liquid-cooling type, normally, a heat cycle is made up with the cooler jacket, as the heat-receiving portion thereof, and in more details thereof, it comprises a circulation pump for circulating the liquid coolant mentioned above within the cycle, so-called a radiator, being a heat-radiation portion for irradiating heat of the liquid coolant mentioned above into an outside, and further a coolant tank provided in a part of the cycle depending on the necessity thereof. And, those are connected through a tube made of a metal and/or an elastic material, such as rubber or the like.
Patent Document 1: Japanese Patent Laying-Open No. 2003-304086 (2003);
Patent Document 2: Japanese Patent Laying-Open No. 2003-22148 (2003);
Patent Document 3: Japanese Patent Laying-Open No. 2002-182797 (2002);
Patent Document 4: Japanese Patent Laying-Open No. 2002-189536 (2002); and
Patent Document 5: Japanese Patent Laying-Open No. 2002-188876 (2002).

With the cooling system of the conventional arts mentioned above, in particular, the cooling system of the liquid type, being high in the cooling efficiency, to be used in the personal computer, such as, of the desktop type or the notebook type, and also the server, etc., normally, as a circulation pump to be provided in a part of the heat cycle thereof for driving the liquid coolant, there is applied a pump of the so-called centrifugal type, due to the reasons that an amount of flow obtained therefrom it is large, that it is free from the deterioration due to abrasion and also small in the noises generated therefrom, since it includes only a small portion sliding therein.

On the other hand, in spite of such the advantages mentioned above, however with such the pump of the centrifugal type mentioned above, due to the structure and/or the principle thereof (i.e., being small in capacity of self-feeding, differing form the pump of the volume type, etc.), there is a necessity of filling up the liquid coolant, as a body to be driven therewith, within the pump chamber thereof, in particular, when starting up thereof. Namely, if there is not filled with a sufficient amount of the liquid coolant as a body to be driven within the pump chamber thereof, when it starts up, the centrifugal pump makes so-called an idling, and depending upon the case, it results into a problem that an electric motor for rotationally driving the pump burns out, or a shaft thereof fastens, etc. For this reason, in the case where applying such the pump of the centrifugal type, it is located in a lower portion of the liquid coolant in the disposition thereof.

However, in an electronic apparatus, including a personal computer, of so-called the desktop-type or the notebook-type, and also a server, etc., accompanying the demands upon small-sizing of the equipment itself in recent years, there is also strongly made a requirement of making small the cooling system in the sized, to be used in this. For such the reasons, due to the high cooling efficiency thereof, attentions are paid upon the cooling system of the liquid type, in particular, with using the liquid coolant, such as, water, for example, and also applying the pump of the centrifugal type therein. However, due to the requirement of small-sizing thereof, it is not necessarily in such a situation that the pump can satisfy such the requirement on the disposition or posture thereof mentioned above, fully.

### SUMMARY OF THE INVENTION

Then, according to the present invention, being accomplished by taking the drawbacks of the conventional arts mentioned above into the consideration thereof, in more details, it is an object to provide an electronic apparatus for dissolving such the problems coming up in the cooling system of the liquid type, applying the pump of the centrifugal type therein; in particular, a cooling system of the structure being applicable into a personal computer, of so-called the desktop-type or the notebook-type, and/or a server, etc., easily, and further, to an electronic apparatus having such the cooling system therein.

According to the present invention, for accomplishing such the object mentioned above, firstly, there is provided an electronic apparatus, installing a semiconductor element within a housing thereof, which necessitates cooling for maintaining normal operation thereof, in a part of the housing, and having a cooling system, within said housing or in a part thereof, said cooling system, comprising: a cooling jacket, being thematically connected with said semiconductor element, for transmitting heat generated therein to a liquid coolant flowing within an inside thereof; a radiator for radiating the heat transmitted into the liquid coolant within said cooling jacket into an outside of the apparatus; and a circulation pump for circulating said liquid coolant in a loop, including said cooling jacket and said radiator therein, wherein: said circulation pump is built up with a rotor formed with a plural number of blades in a centrifugal manner, a pump chamber receiving said rotor, in a rotatable manner, within an inside thereof, and an electric motor for rotationally driving said rotor, being formed together into one body, and said pump chamber is located in a lower portion of said electric motor.

Also, according to the present invention, in the electronic apparatus as described in the above, it is preferable that said circulation pump building up said liquid cooling system has an inlet opening passage for guiding the liquid coolant into said pump chamber, and said inlet opening passage is formed, extending from an upper portion of said pump chamber to a lower portion thereof , and further that said inlet opening passage is formed within an inside of a rotation shaft, for supporting said rotor, rotatabley, in said circulation pump. Also, according to the present invention, in the electronic apparatus as described in the above, it is preferable that an outlet of the liquid coolant, coming out from said circulation pump building up said liquid cooling system, is formed at a position upper than the position of the blades of said rotor, which is disposed within said pump chamber.

In addition thereof, according to the present invention, in the electronic apparatus as described in the above, it is preferable that said liquid cooling system further comprises a tank, which can supply the liquid coolant therein, always irrespective of direction of disposition thereof, and an outlet of said tank is connected to an inlet of said circulation pump.

Further, according to the present invention, for accomplishing the object mentioned above, there is also provided a liquid cooling system, for cooling a semiconductor element generating heat therefrom, comprising: a cooling jacket, being thematically connected with said semiconductor element, for transmitting heat generated therein to a liquid coolant flowing within an inside thereof; a radiator for radiating the heat transmitted into the liquid coolant within said cooling jacket into an outside of the apparatus; and a circulation pump for circulating said liquid coolant in a loop, including said cooling jacket and said radiator therein, wherein: said circulation pump is built up with a rotor formed with a plural number of blades in a centrifugal manner, a pump chamber receiving said rotor, in a rotatable manner, within an inside thereof, and an electric motor for rotationally driving said rotor, being formed together into one body, and said pump chamber is located in a lower portion of said electric motor.

Also, according to the present invention, in the liquid cooling system as described in the above, it is preferable that said circulation pump building up said liquid cooling system has an inlet opening passage for guiding the liquid coolant into said pump chamber, and said inlet opening passage is formed, extending froman upper portion of said pump chamber to a lower portion thereof.

Also, according to the present invention, in the liquid cooling system as described in the above, it is preferable that said inlet opening passage is formed within an inside of a rotation shaft, for supporting said rotor, rotatabley, in said circulation pump, and further that an outlet of the liquid coolant, coming out from said circulation pump building up said liquid cooling system, is formed at a position upper than the position of the blades of said rotor, which is disposed within said pump chamber.

In addition thereto, according to the present invention, in the liquid cooling system as described in the above, it is preferable that said liquid cooling system further comprises a tank, which can supply the liquid coolant therein, always irrespective of direction of disposition thereof, and an outlet of said tank is connected to an inlet of said circulation pump.

### BRIEF DESCRIPTION OF THE VARIOUS VIEWS OF THE DRAWING

Those and other features, objects and advantages of the present invention will become more apparent from the following description when taken in conjunction with the accompanying drawings wherein:
Figs. 1(a) and 1(b) are an upper view and a vertical cross-section view, in particular, for showing the detailed structure of a circulation pump in a cooling system, according to one embodiment of the present invention;
Fig. 2 is a perspective view for showing an example of the arrangement of each part partially exploded thereof, within a personal computer of so-called the desktop type, for example;
Fig. 3 is a perspective view, in particular, for showing a cooling system within an electronic circuit portion, in the electronic apparatus, according to the one embodiment mentioned above;
Figs. 4(a) and 4(b) are perspective views of a rotor in the circulation pump mentioned above, for showing the detailed structure thereof, seeing it from above and below, obliquely;
Fig. 5 is a vertical cross-section view for showing the structure of a circulation pump, according to other embodiment of the present invention;
Fig. 6 is a vertical cross-section view for showing the structure of the circulation pump, which was shown in the above as one example thereof, but according to other embodiment of the present invention;
Fig. 7 is a perspective view for showing the other structure of the liquid cooling system in the electronic apparatus, according to other embodiment of the present invention;
Figs. 8(a) and 8(b) are perspective views, including the cross-section views thereof, for showing a coolant tank to be used in the liquid cooling system, according to the other embodiment mentioned above, for storing a liquid coolant therein, corresponding to various disposition conditions thereof; and
Figs. 9(a) and 9(b) are also perspective views, including the cross-section views thereof, for showing a coolant tank to be used in the liquid cooling system, according to the other embodiment mentioned above, for storing a liquid coolant therein, corresponding to various disposition conditions thereof.

### DETAILED DESCRIPTION OF THE INVENTION

Hereinafter, explanation will be given about the embodiments according to the present invention, in details thereof, by referring to the drawings attached herewith.

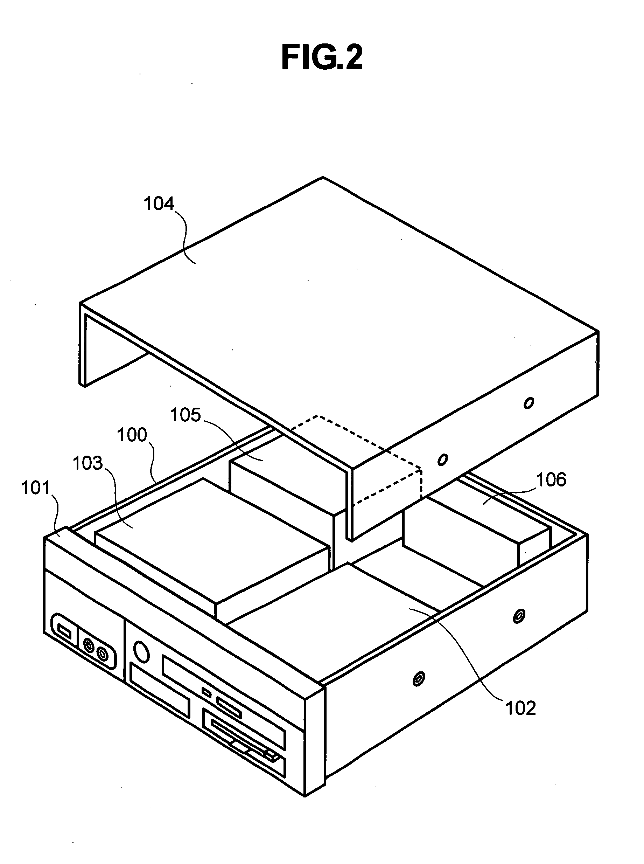

First of all, Fig. 2 attached herewith shows an example of the entire structure of an electronic apparatus having a liquid cooling system therein, according to one embodiment of the present invention. However, in this embodiment is shown a case, where the present invention is applied into a main part or portion of a personal computer, such as, of the desktop type, for example.

As shown in the figure, the main portion of the desktop type personal computer comprises a housing 100, which is formed from a metal plate into a cubic shape thereof, for example, and on a front panel portion 101 thereof are provided various kinds of switches, including an electric power switch therein, and indicator lamps, etc. Also, within an inside thereof is disposed a driver device 102, for driving various kinds of external information recording medium, such as, a floppy disk, a CD, and a DVD, etc., so that it positions an opening thereof on the front panel portion 101. Also, a reference numeral 103 in the figure depicts a memory portion provided within the housing 100 mentioned above, comprising a hard disk device, for example. And also, a reference numeral 104 in the figure depicts a cover to be put on the housing 100 mentioned above.

While on a rear side of the housing 100 is disposed an electronic circuit portion 105, having a liquid cooling system according to the present invention, and a reference numeral 106 in the figure depicts an electric power source portion for supplying from a commercial electric power source, a desired electric power to each of the portions, including, the driver device 102, the memory portion 103, and the electronic circuit portion 105 mentioned above.

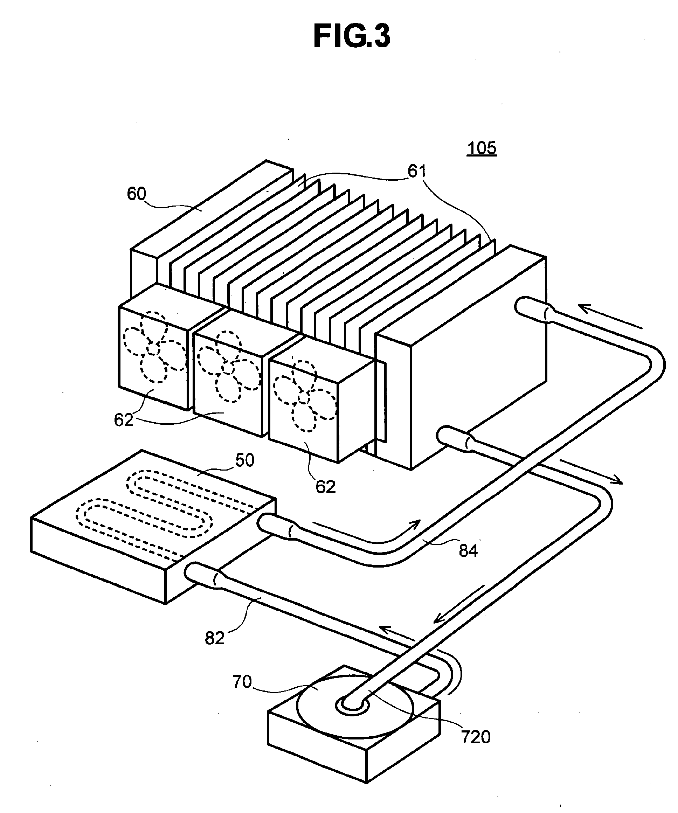

Next, in Fig. 3 attached herewith is shown the electronic circuit portion 105 of the electronic apparatus, the brief structure of which was explained in the above; i.e., within the desktop type personal computer, in particular, mainly around a heat receiving jacket 50 for mounting thereon a heat-generation element, such as, a CPU, as a main or principle structure thereof. However, in this embodiment, a chip 200 of the CPU, being the heat-generation element, is mounted on the lower side surface of the heat-receiving jacket 50 mentioned above, being in contact with, directly, therefore it is not illustrated on the figure, herein.

And, as is apparent from the figure, this electronic circuit portion 105 comprises the above-mentioned heat-receiving (or cooling) jacket 50 for mounting the CPU thereon, a radiator portion 60 for radiating heat generated from the CPU into an outside of the apparatus, a pump 70 for building up a cooling system, and further flow passages are formed by connecting tubes (conduits) 81, 82..., being made of a metal, or an elastic material, such as a rubber or the like, being covered with a metal film, etc., on the outer surface thereof, so as to prevent the liquid coolant inside from leaking outside, for conducting a liquid coolant (for example, a water, or a mixture of water with a so-called anti-freezing solution, such as, propylene glycol, at a predetermined ratio thereof) to each of those portions building up the heat cycle . Also, in a part of the radiator portion 60 mentioned above, there are attached plate-like shaped fans 72, 72... (in a plural number, such as, three (3) pieces, in the present example), directing into an outside of the apparatus, so as to blow an air onto a large number of metal thin pipes 61, 61... as the constituent elements thereof, which will be mentioned in more detail later, thereby radiating the heat transmitted from the heat receiving jacket 50 mentioned above, compulsively. Further, this heat-receiving (or cooling) jacket 50 is a plate-like member, being made of a metal having high heat conductivity, such as cupper or the like, and being formed with a cooling passage within an inside thereof, to conduct or communicated the liquid coolant into the passage thereof, thereby removing (moving) the heat generated from the CPU into the outside.

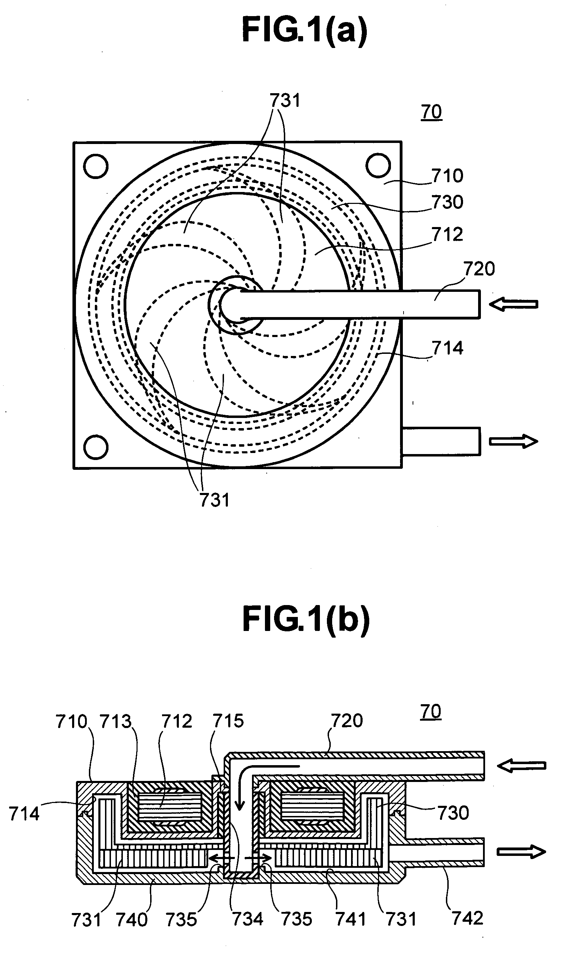

Following to the above, Figs. 1(a) and 1(b) attached herewith show an upper view of the circulation pump 70 mentioned above, and at the same time, a vertical cross-section view thereof. Namely, in this circulation pump 70, as shown in those figures, within an inside of a box (i.e., a case) 710 having a shape of quadrate or square in an outer configuration thereof, a field coil 712 building up a D-C motor, as an electric motor for driving the pump rotationally, being molded around the periphery thereof by an insulating resin 713 in one body, and further a ring-like gutter or groove 714 is formed surrounding around the periphery of the field coil 712, and into an inside thereof are disposed magnet electrodes of the DC motor, which will be mentioned later. Also, on an upper surface of this square-shaped box(i.e., the case) 710, there is formed a suction port 720 of the liquid coolant extending into a central portion thereof. This suction port 720 extends a little bit while being bent downwards, at the central porting thereof. Further, as is apparent from the figures, at the central portion of the square-shaped box (i.e., the case) 710, there is attached so-called an outer-ring shaft bearing 715, in an inside thereof is inserted a rotation shaft of the rotor, which will be mentioned later.

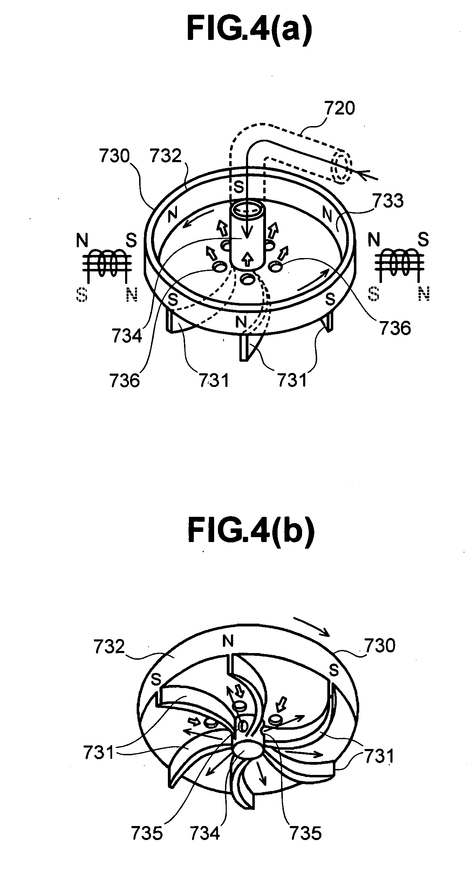

On the other hand, the rotor 30 is built up with a plural number of blades 731, 731... (in the present example, six (6) pieces thereof) formed upon a disk-like member (in the figure, on the lower surface thereof), as is apparent from Figs. 1(a) and 1 (b) and further Figs. 4 (a) and 4 (b) attached herewith. Then, this rotor 730 comprises a ring-like portion 732 extending upwards from an outer edge of that disk-like member, and also on an interior wall surface of this ring-like portion 732 is attached a ring-like shaped permanent magnet 733, being positioned (or magnetized) with the N pole and the S pole, alternately, as shown in the figure, for example. In addition thereto, at the central portion of this rotor 730 made from the disk-like member, there is attached so-called a rotation shaft 734, which is made of a metal or a ceramic and formed into a cylindrical shape, penetrating through the disk-like member.

Namely, as is apparent from the figures mentioned above, the rotor 730 is inserted into from the below in the figure, while fitting or inserting the rotation shaft 734 thereof into the outer-ring shaft bearing 715 of the box (i.e., the case) 710 and at the same time positioning the ring-like portion 732 thereof within the groove 714, being ring-like in the outer configuration thereof, of the box (i.e., the case) 710 mentioned above. Thereafter, on the lower surface of the box (i.e., the case) 710, a lower portion box (i.e., a case) 740 is attached covering over the entire thereof, so that the plural number of blades 731, 731... of the rotor 730 are received within an inside thereof. Thus, between the upper surface of this lower box (i.e., the case) 740 and the lower surface of the rotor mentioned above, a pump chamber 741 is defined for suppressing the liquid coolant therein, and further, this pump chamber 741 is formed to be located in the lower side of the electric motor portion for driving the pump rotationally. Also, a reference numeral 742 depicts a discharge port for the liquid coolant, which is formed in a portion of the lower box (i.e., the case) 740 mentioned above.

In this manner, in the circulation pump 70, the structure of which was mentioned in the above, the flow passages for guiding the liquid coolant in an inside thereof are formed within an inside of the rotation shaft 734, which supports the rotor 730, rotatably, and further on the lower portion of this rotation shaft 734 (i.e., in an area where the blades 731, 731... are formed) are opened a plural number of penetrating holes 735. For this reason, when operating, the liquid coolant reaching into the inside of the rotation shaft 734 of the rotor 730 is guided into an inside of the pump chamber 741 mentioned above, and is compressed therein with the centrifugal force, by means of the plural number of the blades 731, 731..., and thereafter being discharged from the discharge port 742 mentioned above.

On the other hand, within the calculation pump 70, when stopping the operation thereof, the rotor 730 ends the rotation thereof, and accompanying with this, the cooling liquid guided within the pump chamber 742 is accumulated within an inside of the pump, including bubbles and so on in a portion thereof. In that instance, as is apparent from Figs. 4(a) and 4(b) mentioned above, in the vicinity of the disk-like member, the penetrating holes 736, 736... for use of babble removal are formed, respectively, on the lower surface of which the centrifugal blades 731, 731..., therefore, while a portion thereof moves into an upper portion thereof through the rotation shaft 734 mentioned above, the gas moves into an outside of the pump chamber 741, in more details, into an upper portion of the ring-like groove 714 formed in the box (i.e., the case) 710, through the penetrating holes 736, 736... for use of bubble removal, even if the gas mixing therein is separated from the liquid coolant. In other words, within the circulation pump 70 having such the structure mentioned above, only the liquid coolant accumulates within the pump chamber 741, however the gas mixing in the liquid coolant never remains within the pump chamber 741, even when stopping.

For this reason, within the circulation pump 70 having such the structure mentioned above, even when the operation is resumed (or stared) again, after temporal stoppage thereof, since only the liquid coolant always fills up within the pump chamber 741, fully, which receives the blades 731 within the inside thereof, then the pump will never run idle, therefore it is possible to obtain (re-start) the pump operation of the liquid coolant, with certainty. Namely, the circulation pump 70 mentioned above is installed within a part of the main body of the personal computer of the desktop type shown in Fig. 2 mentioned above, and also it can perform the necessary pump operation, with certainty, even in the case if it is disposed in any position within the liquid cooling system having such the structures shown in Fig. 3 mentioned above.

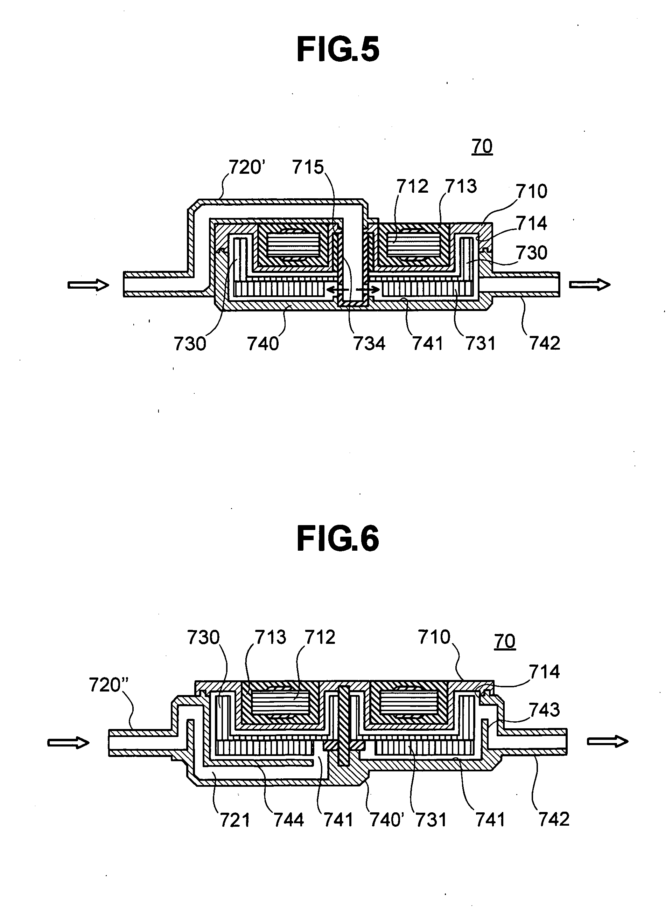

Also, Fig. 5 attached herewith shows other embodiment of the circulation pump 70 mentioned above, and in this embodiment, the passage, in which the suction port 720' of the liquid coolant is opened, is formed covering over from a side surface of the box (i.e., the case) 710, up to the central portion on the upper surface thereof, while being attaching on the wall surface and bent. Namely, with such the structure, upon when stopping the operation of the circulation pump 70, the liquid coolant, which has been circulating up to that time, can easily stay in the suction port 720' formed to be bent, and also in that instance, in particular, the liquid coolant flows into the rotation shaft 734 of the rotor 730 mentioned above, and at the same time, the gaseous component mixing into a portion thereof moves into an upper side of the suction port 720'. Namely, in the similar manner to that of the embodiment mentioned above, the pump will never run idle, even when it is resumed (started), again, of the operation after the temporal stoppage thereof, since the liquid coolant fills up always within the pump chamber 741 receiving the blades 731 within the inside thereof, thereby enabling the pump operation of the liquid coolant, with certainty.

Next, Fig. 6 attached herewith shows further other embodiment of the circulation pump 70 mentioned in the above. In this example, differing from the embodiment mentioned above, first a portion 743 of the lower portion box (i.e., the case) 740, building up the side wall of the pump chamber 741 mentioned above, is extended upwards; thus, the opening of the discharge port 742 to the pump chamber 741 is disposed, so that the position thereof comes to be upper than that of the centrifugal blades 731, 731... of the rotor 730.

Also, in the present embodiment, the suction port 720" for the liquid coolant are formed in one body, together with the discharge port 742 mentioned above, on the lower box (i.e., the case) 740 building up the circulation pump 70 mentioned above. Namely, as is apparent from the figure, this suction port 720", differing from the embodiment mentioned above, is attached on the side surface of the circulation pump 70. And, in more details, this suction port 720", as is apparent from the figure, reaches up to the lower surface of the lower box (i.e., the case) 740, after bending upwards, once, and thereafter, it extends on the lower surface of the lower box (i.e., the case) up to the central portion thereof (i.e., the lower surface extending portion 721), and it opens directing from a lower wall surface 744 in vicinity of the central portion of the rotor 730 mentioned above, into an inside of the pump chamber 741. However, in this example, in the place of the hollow rotation shaft 734 mentioned above, a rod-like rotating shaft 734' is attached at the central portion of the rotor 730, and on the other hand, on the side of the lower box (i.e., the case) 740 is attached a plate-like outer-ring shaft bearing 715' , into the hollow portion thereof the rod-like rotation shaft 734' is inserted, thereby supporting the rotor 730, rotatably.

With such the structure of the further other embodiment mentioned above, as is apparent from the figure, when the pump 70 stops, the rotor 730 also stops the rotation thereof. And, accompanying with this, the liquid coolant guided into the pump chamber 742 accumulates within the inside of the pump, containing bubbles and so on, in a part thereof. In that instance, as was mentioned above, since the position of the discharge port 742 opening into the pump chamber 741 is arranged so that it comes to be lower than that the centrifugal blades 731, 731... of the rotor, and further since the suction port 720" is opened at around the central portion of the pump chamber 741 from a lower wall surface thereof, after being bent up and down, once, on the side surface of the pump, the gas is guided into the outside passing through the opening of the discharge port 742 disposed at the position above than the centrifugal blades 731, 731... of the rotor 730, even if the gas mixing therein is separated from the liquid coolant accumulated within the pump, therefore only the liquid coolant is accumulated within an inside of the pump chamber 741, which receives the centrifugal blades 731, 731... therein. In other words, during the time when stopping, no gas mixing into the liquid coolant is accumulated within the pump chamber 741, thereby bringing about no idling run of the pump when it is re-started.

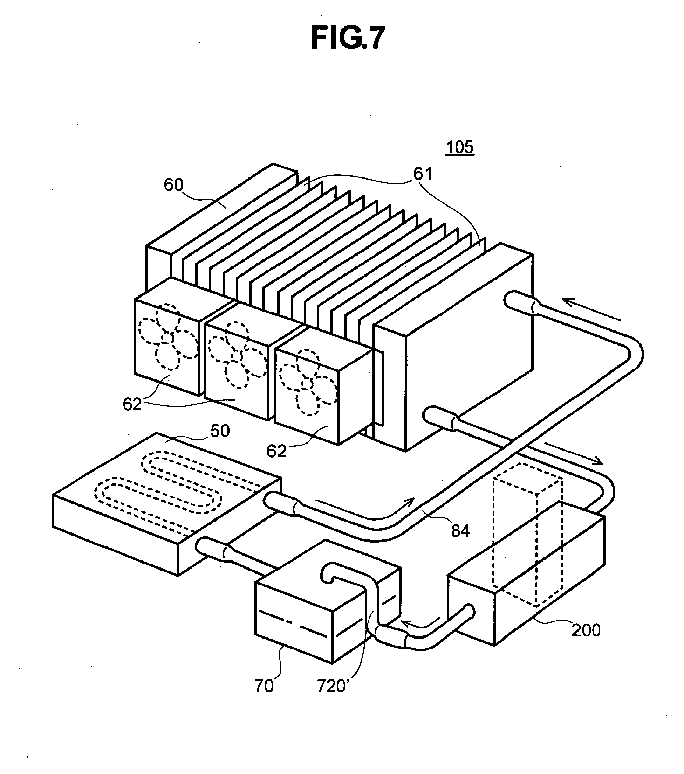

Following to the above, Fig. 7 attached herewith shows other liquid cooling system, according to further other embodiment of the present invention. However, in this embodiment, the numeral references being same to those shown in Fig. 3 mentioned above depict the constituent elements, which are same to those shown in the embodiment mentioned above. Namely, as is apparent from those figures, in this further other embodiment, between the radiator 60 and the circulation pump 70 building up the cooling system, a coolant tank 200 is further provided between the radiator 60 and the circulation pump 70 mentioned above, building up the cooling system, for the purpose of storing or accumulating the liquid coolant; e.g., the water or the mixture of the water and the anti-freezing solution, such as, propylene glycol or the like, in an inside thereof, to be circulated within the inside of the system. However, there may be cases where, this coolant tank 200 is located horizontally, as is indicated by solid lines in the figure, or vertically, as is indicated by broken lines in the figure, for example, depending upon the restriction of the space within an inside thereof, for example, when it is disposed within the inside of the housing 100 of the desktop type personal computer shown in Fig. 2 in the above.

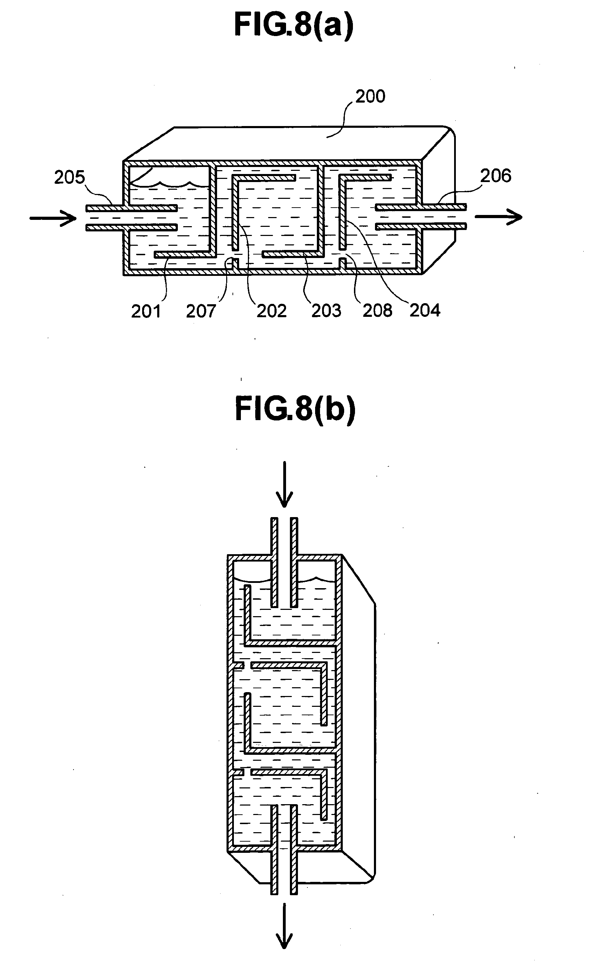

Then, this coolant tank 200 has the structure, as shown in Figs. 8(a) and 8(b) attached herewith, wherein the coolant storage space defined within the inside thereof is divided into a plural number of spaces (for example, three (3) spaces SP1, SP2 and SP3, in the present embodiment), with forming labylinth by combining partition walls 201, 202, 203 and 204, each having about "L"-like cross-section shape. Also, a reference numeral 205 in the figure indicates an inlet for the liquid coolant flowing into from the radiator 60 mentioned above, and 206 an outlet for the liquid coolant flowing out into the circulation pump 70 mentioned above. Further, reference numerals 206 and 207 indicate portions of the partition walls 202 and 204, each having the "L"-like cross-section; thus, an opening portion that is formed at the position in the vicinity of an outer periphery of the tank.

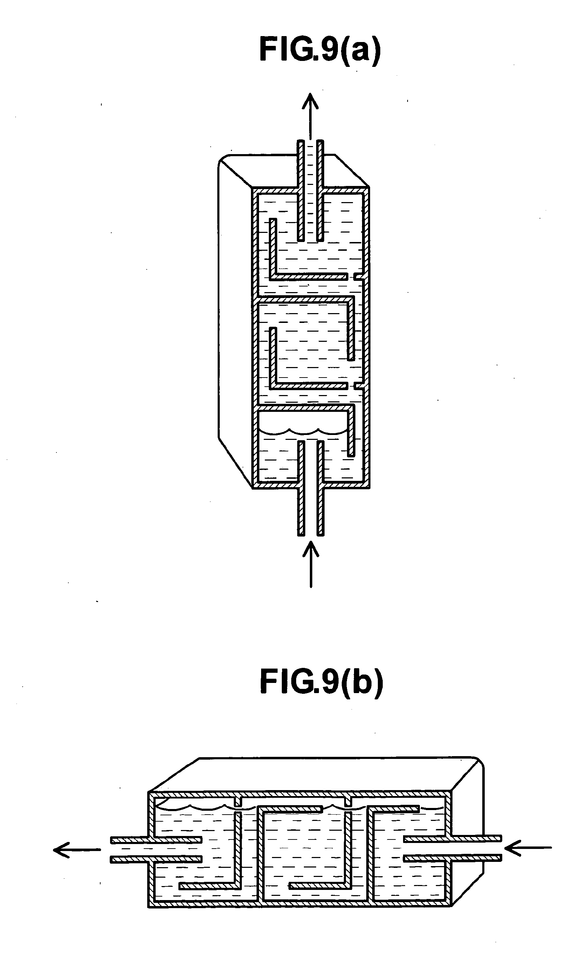

In accordance with the coolant tank 200 having such the structure therein, as is apparent from Figs. 8(a) and 8(b) mentioned above, and further Figs. 9(a) and 9(b) attached herewith, if a bubble flows into the inlet 205 of the tank, mixing into a portion of the liquid coolant while the portion thereof leaks out through vaporization, etc., into an outside thereof, during it circulates within the cooling system, however, only the liquid coolant, but excluding the bubble therefrom, is always sent out from the outlet 205 to the circulation pump mentioned above. Therefore, it is possible to protect the circulation pump, building up an important constituent element in the cooling system of using the liquid coolant therein, in particular, from the idling due to the gas existing within the pump chamber 741 when it is started, and also from the damage of the circulation pump in itself, depending on a case, with certainty; thereby, obtaining the electronic apparatus having the cooling system superior in the cooling capacity, which can be applied into the personal computer, of so-called the desktop type or the notebook-type, and also the server, etc.

Though the mentioning given in the above was made only about the one example of the case where the liquid cooling system of using the liquid coolant therein according to the present invention is applied, in particular, into the main part of the personal computer of so-called the desk-top type, however the present invention can be also applied into the personal computer of so-called the notebook type and the server, etc. However, in that case, an in particular, in the former case, it would be obvious matter that, for the person stilled in the art, for example, in particular, as the radiator portion 60 among the constituent elements thereof, a radiation plate, which is built up with a metal plate attached with a conduit made of a metal, is attached on the cover side thereof, in more details thereof, the reverse side surface of the liquid crystal display device in the place of that mentioned in the above.

Namely, according to the present invention fully mentioned above, it is possible to provide the liquid cooling system, being applicable into the electronic apparatus, such as, the personal computers, of so-called the desktop-type and the notebook-type, and further the server, etc., easily, and having a high cooling efficiency with using the pump suitable for small-sizing thereof, and also the electronic apparatus having such therein, thereby enabling to dissolve the problems at the time of starting mentioned above, in particular, even when applying the centrifugal pump therein.

The present invention may be embodied in other specific forms without departing from the spirit or essential feature or characteristics thereof. The present embodiment(s) is/are therefore to be considered in all respects as illustrative and not restrictive, the scope of the invention being indicated by the appended claims rather than by the forgoing description and range of equivalency of the claims are therefore to be embraces therein.

## Claims

1. An electronic apparatus, installing a semiconductor element within a housing thereof, which necessitates cooling for maintaining normal operation thereof, in a part of the housing, and having a cooling system, within said housing (100) or in a part thereof, said cooling system, comprising:
a cooling jacket (50), being thematically connected with said semiconductor element, for transmitting heat generated therein to a liquid coolant flowing within an inside thereof;
a radiator (60) for radiating the heat transmitted into the liquid coolant within said cooling jacket (50) into an outside of the apparatus; and
a circulation pump (70) for circulating said liquid coolant in a loop, including said cooling jacket (50) and said radiator (60) therein, wherein:
said circulation pump (70) is built up with a rotor (730) formed with a plural number of blades (731, 732) in a centrifugal manner, a pump chamber (741) receiving said rotor (730), in a rotatable manner, within an inside thereof, and an electric motor for rotationally driving said rotor (730), being formed together into one body, and said pump chamber (741) is located in a lower portion of said electric motor.

2. Electronic apparatus according to claim 1, **characterized in that** said circulation pump (70) building up said liquid cooling system has an inlet opening passage for guiding the liquid coolant into said pump chamber (741), and said inlet opening passage is formed, extending from an upper portion of said pump chamber (741) to a lower portion thereof.

3. Electronic apparatus according to claim 2 , **characterized in that** said inlet opening passage is formed within an inside of a rotation shaft (734), for supporting said rotor (730), rotatably, in said circulation pump (70).

4. Electronic apparatus according to any of claims 1 to 3, **characterized in that** an outlet of the liquid coolant, coming out from said circulation pump (70) building up said liquid cooling system, is formed at a position upper than the position of the blades (731, 732) of said rotor (730), which is disposed within said pump chamber (741).

5. Electronic apparatus according to any of claims 1 to 4, **characterized in that** said liquid cooling system further comprises a tank, which can supply the liquid coolant therein, always irrespective of direction of disposition thereof, and an outlet of said tank is connected to an inlet of said circulation pump (70).

6. A liquid cooling system, for cooling a semiconductor element generating heat therefrom, comprising:
a cooling jacket (50), being thematically connected with said semiconductor element, for transmitting heat generated therein to a liquid coolant flowing within an inside thereof;
a radiator (60) for radiating the heat transmitted into the liquid coolant within said cooling jacket (50) into an outside of the apparatus; and
a circulation pump (70) for circulating said liquid coolant in a loop, including said cooling jacket (50) and said radiator (60) therein, wherein:
said circulation pump (70) is built up with a rotor (730) formed with a plural number of blades (731, 732) in a centrifugal manner, a pump chamber (741) receiving said rotor (730), in a rotatable manner, within an inside thereof ,and an electric motor for rotationally driving said rotor (730), being formed together into one body, and said pump chamber (741) is located in a lower portion of said electric motor.

7. Liquid cooling system according to claim 6, **characterized in that** said circulation pump (70) building up said liquid cooling system has an inlet opening passage for guiding the liquid coolant into said pump chamber (741), and said inlet opening passage is formed, extending from an upper portion of said pump chamber (741) to a lower portion thereof.

8. Liquid cooling system according to claim 6 or 7, **characterized in that** said inlet opening passage is formed within an inside of a rotation shaft (734), for supporting said rotor (730), rotatably, in said circulation pump (70).

9. Liquid cooling system according to any of claims 6 to 8, **characterized in that** an outlet of the liquid coolant, coming out from said circulation pump (70) building up said liquid cooling system, is formed at a position upper than the position of the blades (731, 732) of said rotor (730), which is disposed within said pump chamber (741).

10. Liquid cooling system according to any of claims 6 to 9, **characterized in that** said liquid cooling system further comprises a tank, which can supply the liquid coolant therein, always irrespective of direction of disposition thereof, and an outlet of said tank is connected to an inlet of said circulation pump (70).
